(19) Europäisches Patentamt
European Patent Office
Office européen des brevets

(11) **EP 3 435 114 B1**

(12) **EUROPÄISCHE PATENTSCHRIFT**

(45) Veröffentlichungstag und Bekanntmachung des Hinweises auf die Patenterteilung:
**08.09.2021   Patentblatt 2021/36**

(51) Int Cl.:
***G01S 7/527*** *(2006.01)*       ***H03M 7/30*** *(2006.01)*

(21) Anmeldenummer: **18184164.4**

(22) Anmeldetag: **18.07.2018**

(54) **VERFAHREN ZUR ÜBERTRAGUNG VON ULTRASCHALLMESSSIGNALE REPRÄSENTIERENDEN DATEN INSBESONDERE IN EINEM FAHRZEUG**

METHOD FOR THE TRANSMISSION OF DATA REPRESENTING ULTRASOUND MEASURING SIGNALS, IN PARTICULAR IN A VEHICLE

PROCÉDÉ DE TRANSMISSION DE DONNÉES REPRÉSENTANT DES SIGNAUX DE MESURE PAR ULTRASONS, EN PARTICULIER DANS UN VÉHICULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.07.2017   EP 17183696**

(43) Veröffentlichungstag der Anmeldung:
**30.01.2019   Patentblatt 2019/05**

(73) Patentinhaber: **Elmos Semiconductor SE 44227 Dortmund (DE)**

(72) Erfinder: **Egbert, Dr. Spiegel 44227 Dortmund (DE)**

(74) Vertreter: **dompatent von Kreisler Selting Werner - Partnerschaft von Patent- und Rechtsanwälten mbB
Deichmannhaus am Dom
Bahnhofsvorplatz 1
50667 Köln (DE)**

(56) Entgegenhaltungen:
**EP-A1- 3 171 553       EP-A2- 0 273 820
EP-A2- 1 231 481       DE-A1-102013 015 402**

- **LUDLOFF A: "Praxiswissen radar und radarsignalverarbeitung", PRAXISWISSEN RADAR UND RADARSIGNALVERARBEITUNG, XX, XX, 1. Januar 1998 (1998-01-01), Seiten 8-6, XP002221116,**

EP 3 435 114 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Übertragung von ein Ultraschallmesssignal einer Ultraschallmessvorrichtung insbesondere eines Fahrzeugs repräsentierenden Daten von einem Sender, insbesondere einem Ultraschallsensor, an einen Empfänger, bei dem es sich insbesondere um eine Zentraleinheit (Steuergerät) handelt.

Ultraschallmessvorrichtungen finden bei Fahrzeugen insbesondere als Einparkhilfen (USPA) Anwendung. Durch Ultraschallmessvorrichtungen sollen aber zukünftig mehr und mehr Informationen über das Umfeld eines Fahrzeugs erzielt werden können.

Bei den bekannten Ultraschallmessvorrichtungen, die mit Ultraschallsendern und Ultraschallempfängern, zumeist in Form von Ultraschalltransducern arbeiten, findet die Signalauswertung bisher vornehmlich im eigentlichen Sensormodul also entfernt vom die Ultraschallmessvorrichtung steuernden Steuergerät (Zentraleinheit) statt. Die Signalverarbeitung beschränkt sich im Wesentlichen auf die Ermittlung der Positionen erkannter Objekte relativ zum Fahrzeug. Diese Informationen werden dann vom Sensormodul bzw. von den Sensormodulen an das Steuergerät übertragen. Weitergehende Daten können insbesondere wegen der begrenzten Datenübertragungsrate der für Fahrzeuge verwendeten Datenbussysteme nur eingeschränkt übertragen werden.

In EP-A-0 273 820 ist ein Verfahren zur Messsignalübertragung von einem Sender an einen Empfänger beschrieben. Dabei wird das Messsignal in den Frequenzbereich transformiert, um den vom gesamten Spektrum abgedeckten Amplitudenbereich zu skalieren. Danach erfolgt eine Frequenzfilterung.

Weitere Datenübertragungsverfahren sind aus DE-A-10 2013 015 402 und EP-A-3 171 553 bekannt.

Aufgabe der Erfindung ist es, die Signalverarbeitung von Ultraschallmesssignalen, die insbesondere von einer Vielzahl von Sensoren geliefert werden, zu verbessern. Hierzu gehört insbesondere eine effiziente Rohdatenübertragung von den Sensormodulen an die Zentraleinheit.

Zur Lösung dieser Aufgabe wird mit der Erfindung ein Verfahren zur Übertragung von ein Ultraschallmesssignal einer Ultraschallmessvorrichtung insbesondere eines Fahrzeugs repräsentierenden Daten von einem Sender an einen Empfänger vorgeschlagen, wobei bei dem Verfahren

- im Sender

  - ein digitalisiertes Analog-Ultraschallmesssignal als Reaktion auf ein zur Detektion von Hindernissen ausgesandtes Analog-Ultraschallsendesignal vorliegt,
  - das Ultraschallmesssignal senderseitig bei einem Mehrfachen seiner Frequenz abgetastet und in einzelne aufeinanderfolgende Blöcke von Abtastwerten unterteilt wird,
  - die Abtastwerte des abgetasteten Ultraschallmesssignals blockweise in den Frequenzbereich transformiert werden, und zwar mittels segmentierter, schneller Faltung,
  - diejenigen Frequenzanteile des Spektrums, deren Amplitude kleiner als ein vorgebbarer Schwellwert ist, oder die Frequenzanteile des Spektrums oberhalb eines oberen Frequenzgrenzwerts und/oder unterhalb eines unteren Frequenzgrenzwerts entfernt werden,
  - der von dem verbleibenden Frequenzspektrum abgedeckte Amplitudenbereich zur weiteren Reduktion der Daten um einen Skalierungsfaktor skaliert wird, und

- von dem Sender die Daten jedes Blocks mit dem dem betreffenden Block jeweils zugeordneten Skalierungsfaktor an den Empfänger übertragen werden und
- im Empfänger

  - die Skalierung des Amplitudenbereichs des Frequenzspektrums jedes Blocks mittels des jeweiligen Skalierungsfaktors wieder rückgängig gemacht wird,
  - das so bearbeitete Frequenzspektrum durch Multiplikation mit Filterkoeffizienten eines Optimalfilters zur Extraktion der Signalform des Analog-Ultraschallsendesignals aus dem im Sender vorliegenden Analog-Ultraschallmesssignal gefiltert wird und
  - das derart gefilterte Frequenzspektrum blockweise in den Zeitbereich rücktransformiert wird, und zwar mittels inverser segmentierter, schneller Faltung.

Mit der Erfindung wird sinngemäß vorgeschlagen, die Rohdaten analoger Ultraschallmesssignale blockweise unter Anwendung der segmentierten Faltung zu übertragen, wobei lediglich die Daten des relevanten Signalspektrums unter Anwendung der segmentierten Faltung übertragen werden. Dadurch lässt sich eine Übertragung der Sensorrohdaten mit hoher zeitlicher Auflösung und geringer Latenzzeit an eine Zentraleinheit (Steuergerät) des Fahrzeugs über einen im Automobilbereich gebräuchlichen Bus mit "mittlerer" Datenrate (z.B. DSI3) realisieren. An die Zentraleinheit können von mehreren Ultraschallsensoren Rohdaten für die weitere, insbesondere integrative Verarbeitung der Roh-

**EP 3 435 114 B1**

daten mehrerer bzw. aller angeschlossenen Ultraschallsensoren übertragen werden.

Dadurch, dass erfindungsgemäß die Datenkompression erst nach der Transformation des zu übertragenden Ultraschallmesssignals in den Frequenzbereich erfolgt, wird erreicht, dass durch eine Filterung des transformierten Signals durch z.B. Entfernen von Frequenzen, deren Signalanteile kleiner als ein Vorgabewert sind, oder außerhalb (d.h. unterhalb und/oder oberhalb) von Grenzwerten liegen, nur noch die "gewollten" Signalanteile komprimiert werden. Diese Vorgehensweise liefert genauere Ergebnisse als in dem Fall, in dem die Datenkompression vor der Transformation des Signals in den Frequenzbereich erfolgt.

Auch die erfindungsgemäß vorgesehene blockweise Fourier Transformation durch segmentierte, schnelle Faltung bietet Vorteile gegenüber bekannten Verfahren. Dann nämlich kann die Filterung des Signals (zur Extraktion derjenigen Signalform im Analog-Ultraschallmesssignal, die auf Reflektionen an Hindernissen des Analog-Ultraschallsendesignals zurückzuführen sind,) durch Faltung mit der Impulsantwort eines Optimalfilters durchgeführt werden. Diese Faltungsoperation lässt sich nämlich nach der Transformation des Analog-Ultraschallmesssignals in den Frequenzbereich als Multiplikation ausführen, indem die den einzelnen Frequenzen zugeordneten Filterkoeffizienten des Optimalfilters mit den Signalanteilen des Frequenzspektrums des Ultraschallmesssignals bei den jeweiligen Frequenzen multipliziert werden. Mit anderen Worten erfolgt also eine Multiplikation des Frequenzgangs des Filters mit dem Frequenzspektrum des Analog-Ultraschallmesssignals. Durch diesen "Umweg über den Frequenzbereich" lassen sich sehr viele Rechenoperationen einsparen.

Eine weitere Besonderheit des erfindungsgemäßen Konzepts und damit eine weitergehende Abkehr von bisherigen USPA-Systemen besteht darin, dass der ganz überwiegende Teil der Signalverarbeitung nicht mehr im Sensormodul sondern in der Zentraleinheit (Steuergerät) in Form von Software erfolgt ("Software-Defined-USPA").

Im Sensormodul braucht lediglich noch die Digital-Analog-Wandlung des analogen Ultraschallmesssignals und die an sich bekannte und typischerweise eingesetzte I/Q-Demodulation zu erfolgen. Ebenfalls durchgeführt im Sensormodul wird die blockweise Fast Fourier Transformation (FFT) mit segmentierter Faltung und mit der erfindungsgemäß vorgesehenen Beschränkung des Frequenzspektrums auf die relevanten Signalfrequenzanteile. Zum erfindungsgemäßen Konzept und damit zum erfindungsgemäßen weiteren Kompressionsschritt gehört auch die sogenannte blockweise Skalierung, d.h. die Reduzierung höher auflösender Bitwörter auf Bitwörter mit geringerer Anzahl von Bits. Damit beschränkt sich die Signalverarbeitung im Sensormodul auf die Verarbeitung der reinen Sensorrohdaten, die also dann komprimiert über den Automobil-Datenbus des USPA-Systems übertragen werden, um dann in der Zentraleinheit (Steuergerät) blockweise wieder re-skaliert und zurück in den Zeitbereich transformiert werden.

Mit dem erfindungsgemäßen Konzept ist es möglich, grundsätzlich sämtliche Echoauswertealgorithmen in Software in der zentralen Steuereinheit ablaufen zu lassen ("Software-Defined-USPA"). Außerdem besteht eine hohe Flexibilität des Systems bei der Implementierung neuer Signalauswertefunktionen. Schließlich lassen sich standardisierte Sensoren verwenden. Insgesamt trägt die Erfindung dazu bei, höherwertige automotive Ultraschallmesssysteme zu realisieren.

In vorteilhafter Weiterführung der Erfindung kann vorgesehen sein, dass die Skalierung erfolgt, indem in einem einen Amplitudenwert beschreibenden Amplituden-Bitwort mit L-Bits dasjenige höchstwertige Bit dieser L-Bits, das ungleich Null ist, identifiziert wird und dieses höchstwertige Bit sowie ausgehend diesem die M-nächst niederwertigen Bits des Amplituden-Bitworts in ein Reduktions-Bitwort der Länge M + 1 mit M + 1 < L umgesetzt werden, wobei der Skalierungsfaktor die Anzahl derjenigen Bits des Amplituden-Bitworts repräsentiert, die höhewertig sind als das identifizierte höchstwertige Bit ungleich Null des Amplituden-Bitworts. Eine zweckmäßige weitere Ausgestaltung der Erfindung kann darin gesehen werden, dass dann, wenn das identifizierte höchstwertige Bit ungleich Null des Amplituden-Bitworts niederwertiger als das (M + 1)-te Bit, vom niederwertigsten Bit des Amplituden-Bitworts an gerechnet, ist, diese (M + 1)-Bits des Amplituden-Bitworts die Bits des Reduktions-Bitworts sind, und dass der Skalierungsfaktor die Anzahl L - (M + 1) repräsentiert.

Schließlich kann vorgesehen sein, wie bereits oben erwähnt, dass das digitalisierte Analog-Ultraschallmesssignal einer I/Q-Demodulation unterzogen wird, wobei die Frequenz, mit der die I/Q-Demodulation durchgeführt wird, gleich der Frequenz des Ultraschallmesssignals ist. Die I/Q-Demodulation erfolgt dabei durch Mischen des AD-gewandelten Ultraschallmesssignals mit einerseits der Trägerfrequenz (zur Ermittlung des I-Anteils der Demodulation) und andererseits der demgegenüber um 90° phasenverschobenen Trägerfrequenz (zur Ermittlung des Q-Anteils der Demodulation).

Die Erfindung wird nachfolgend anhand eines Ausführungsbeispiels sowie unter Bezugnahme auf die Zeichnung näher erläutert. Im Einzelnen zeigen dabei:

Fig. 1      das erfindungsgemäße Prinzip bei der USPA-Datenkompression,

Fig. 2      eine schematische Darstellung zur Erläuterung der schnellen Faltung,

Fig. 3      eine schematische Darstellung zur Erläuterung der segmentierten Faltung,

Fig. 4    beispielhaft ein Spektrum eines 16 Puls Ultraschall-Bursts im Sensor, bezogen auf die Mittenfrequenz,

Fig. 5    eine schematische Darstellung zur Skalierung,

Fig. 6    das Ablaufdiagramm für ein Ausführungsbeispiel der USPA-Datenkompression und

Fign. 7 und 8    Kurvenverläufe als Vergleich vor und nach einer Datenkompression.

In den existieren Ultraschallparkhilfesystem ist die Signalverarbeitung des Empfangskanals vollständig in jedem Sensormodul integriert. Diese besteht neben einen Verstärker und einem ADC aus den folgenden Funktionsblöcken, welche digital realisiert sind:

- Demodulation / Quadraturmischer
- Matched-Filter / Pulskompressions-Filter / Korrelationsgradmesser
- Betragsrechner
- Algorithmen zur "Schärfung" der Echosignale und zur Störunterdrückung, wie Differenzierung (FTC = Fast Time Constant)
- Algorithmen zur automatischen und manuellen Schwellwertgenerierung
- Bestimmung der Echoposition (z.B. "Echo Peak Detection")
- Echobewertung nach Höhe / Fläche / Rauschabstand
- etc.

Diese Funktionen werden fast ausschließlich in digitaler Hardware implementiert. Dies ist kosteneffektiv aber auch unflexibel. Zwar kann dieser Nachteil teilweise durch eine großzügige Parametrisierung aufgehoben werden; die Algorithmen selbst sind aber nicht mehr modifizierbar. Eine Implementierung in Software auf einem entsprechend leistungsfähigen Digital-Signalprozessor (DSP) in jedem Sensormodul wäre die Lösung, ist aber zumindest aktuell noch zu kostspielig.

Bei der Zusammenführung der Echodaten in der zentralen Steuereinheit stehen zu Berechnung des Umfeldes in der Regel nur die Echoposition und in wenigen Fällen auch die Echohöhe zu Verfügung. Für eine präzisere Umfelderkennung ist es erwünscht, der zentralen Steuereinheit die vollständige Hüllkurve in hoher Auflösung zur Verfügung zu stellen. Würde der Hauptteil der Signalverarbeitung in der Zentraleinheit in Form von Software realisiert, so stünde ein sehr flexibles System zur Verfügung, mit funktional einfachen und standardisierten Sensormodulen.

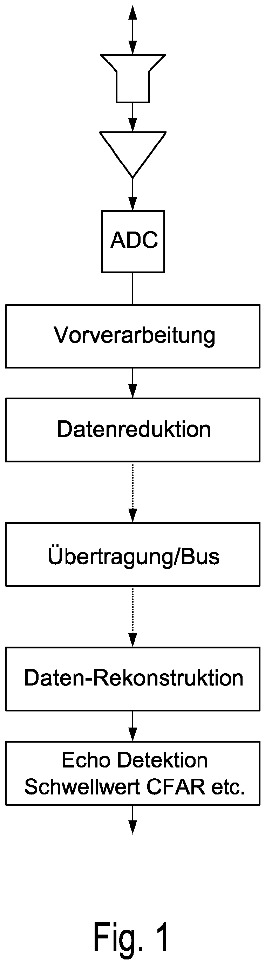

Bei aktuell verwendeten Sensoren steht die Hüllkurve im Zeitraster von ~20 μs mit 16 Bit Auflösung zur Verfügung. Das bedeutet z.B., dass pro 5 ms Messdauer 500 Byte Daten übertragen werden müssen. Der aktuell vorgesehene und als schnell angesehene DSI3 Bus weist dagegen eine Nettoübertragungsrate von lediglich ca. 150 Bytes/5 ms auf. Die Aufgabenstellung ist also, ein Verfahren zu finden, welches die Menge an Daten reduziert, ohne die Signalqualität signifikant zu beeinflussen. Ein solches System ist in Fig. 1 skizziert.

1. Lösung

Die mathematische Basis der Lösung ist die diskrete Faltung. Diese soll hier grob beschrieben werden. Literatur zur diskreten Faltung findet sich z.B. in [1], [2], [3].

1.1 "Schnelle" Faltung

Die Filterung eines Signals kann durch Faltung mit der Impulsantwort des Filters durchgeführt werden:

$$g(t) = s(t) * h(t) = \int_{-\infty}^{\infty} s(\tau)h(t - \tau)d\tau$$

Für diskrete Folgen lässt sich ableiten:

$$g(n) = s(n) * h(n) = \sum_{m=-\infty}^{\infty} s(m)h(n - m)$$

Die Länge des Faltungsproduktes ist

$$L = M_s + M_h - 1$$

Für die Fouriertransformierte der diskreten Faltung gilt:

$$s(n) * h(n) \circ\!\!-\!\!\bullet S(f) \cdot H(f)$$

D.h., dass die Faltungsoperation nach der Transformation in eine Multiplikation übergeht. Durch diesen scheinbaren Umweg lassen sich aber, je nach Länge der Sequenzen, sehr viele Rechenoperationen einsparen. Daher die Bezeichnung "schnelle Faltung".

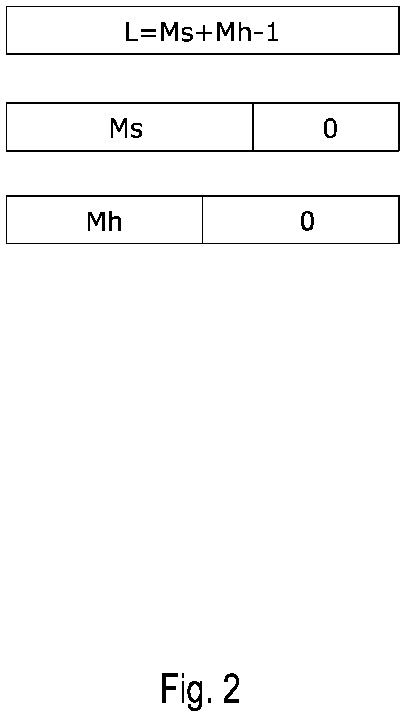

Die Berechnung der schnellen Faltung mittels der schnellen Fouriertransformation (FFT) läuft folgendermaßen ab (siehe auch die schematische Darstellung in Fig. 2):

1. Auffüllen der Folgen mit Nullen bis zur Länge L

2. Fouriertransformation der Folgen

3. Multiplikation der transformierten Folgen

4. Rücktransformation (inverse Fouriertransformation)

## 1.2 Segmentierte Faltung

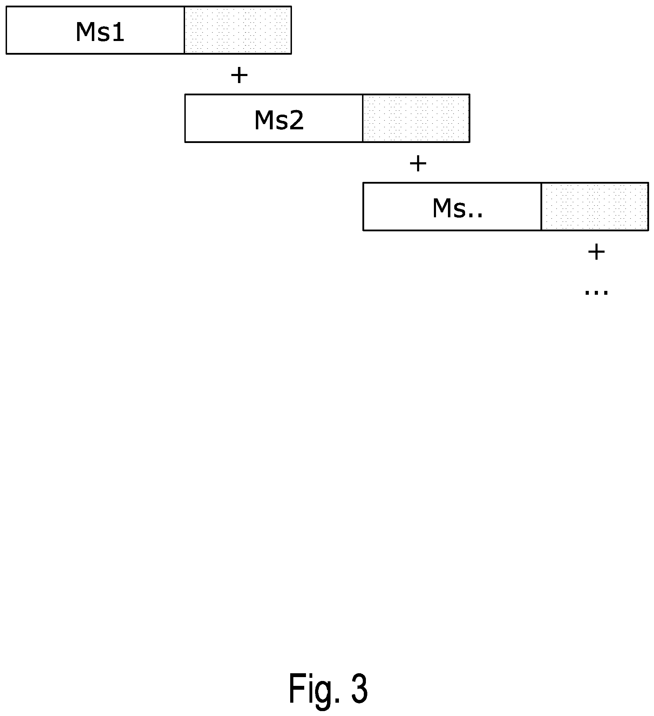

In vielen Fällen ist die Signalfolge sehr lang bzw. auch unendlich lang (durchlaufende Signalverarbeitung). Oft ist auch der Speicher nicht groß genug oder es kann keine größere Verzögerung/Latenz akzeptiert werden. In diesem Fall wird die Eingangsfolge in Teilfolgen zerlegt. Nach der Faltung werden diese Folgen, beispielsweise wie in folgendem Bild, addiert ("Overlapp-and-Add"-Methode - siehe Fig. 3).

## 1.3 Beschreibung der Erfindung anhand eines Ausführungsbeispiels

Die Berechnung der Hüllkurve und die Bearbeitung der nachgelagerten Algorithmen werden im Zeitraster von ~20 μs (Abtastfrequenz 50 kHz) durchgeführt Die Auflösung ist notwendig, um die geforderten Absolutgenauigkeit in der Entfernung von <=1 cm auch tatsächlich zu erreichen. (20 μs entsprechen 3.4 mm).

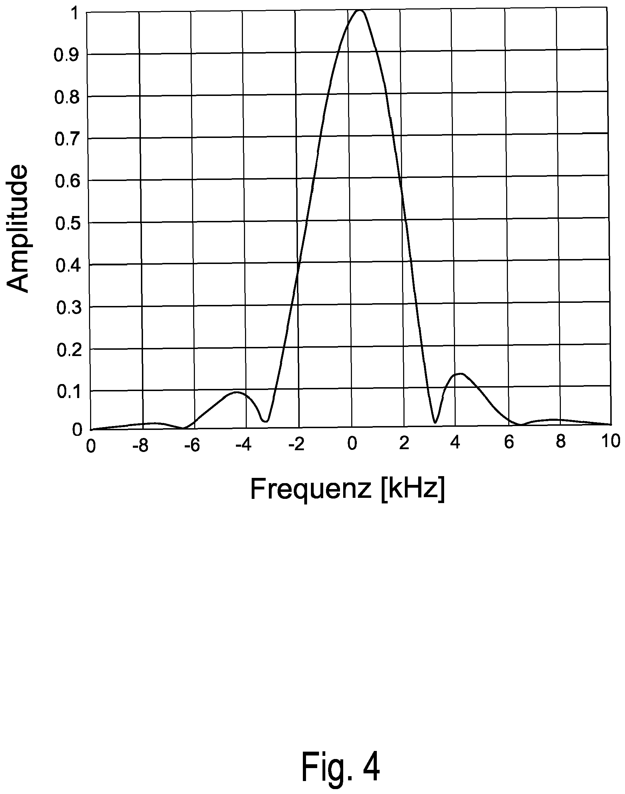

Betrachtet wird das Frequenzspektrum eines Echosignals im Empfänger, das mit 16 Pulsen ausgesendet wurde. Gemessen an der darstellbaren Bandbreite von +/- 25 kHz weist das Echosignal eine signifikante Bandbreite von maximal +/-3 kHz auf (siehe Fig. 4).

Führt man also die Signalübertragung im Frequenz- anstatt im Zeitbereich durch, kann offensichtlich der größte Teil des Signals vernachlässigt werden. In diesem Zusammenhang ist es sinnvoll, das Matched-Filter ebenfalls in die zentrale Steuereinheit zu verlegen, insbesondere wenn es sich um ein aufwendiges Pulskompressionsfilter handelt (für z.B. Chirpsignale). Da die Echodaten im zentralen Steuergerät als Frequenzdaten vorliegen, können diese im zentralen Steuergerät auch sehr effizient nach dem Prinzip der "schnellen Faltung" gefiltert werden. Um den Speicheraufwand im Sensor und vor allem aber die Latenzzeit zu reduzieren, werden die Messdaten blockweise in den Frequenzbereich transformiert. Die Grundlage dafür bietet die sogenannte "segmentierte Faltung". Die Segmentierung bietet weiterhin den Vorteil, jeden Abschnitt separat zu skalieren und somit die Datenmenge noch einmal mindestens um den Faktor zwei zu reduzieren. Bei der Übertragung wird dieser Faktor dem jeweiligen Datenpaket beigefügt, um die Skalierung in der Zentraleinheit wieder rückgängig zu machen.

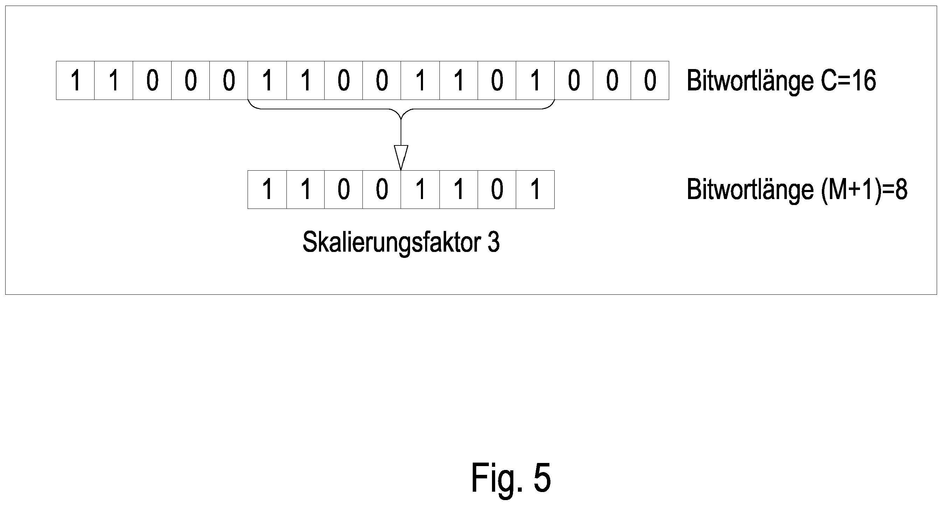

Ein Beispiel für die Skalierung eines Bitworts der Länge L (L = 16 Bit) auf ein Bitwort der Länge M + 1 (z.B. 8 Bit) zeigt Fig. 5. Es wird im Bitwort der Länge L nach dem höchstwertigen Bit gesucht, das ungleich Null ist. Im Beispiel der Fig. 5 ist dies das vierthöchstwertige Bit. Dieses Bit sowie die nächsten sieben niederwertigen Bits werden als reduziertes Bitwort der Länge 8 verwendet. Der Skalierungsfaktor beträgt 3.

Sind die obersten 8 Bit des beispielhaften 16-Bit-langen Bitworts Null, so umfasst das reduzierte Bitwort der Länge 8 die untersten 8 Bits des 16-Bit-langen Bitworts.

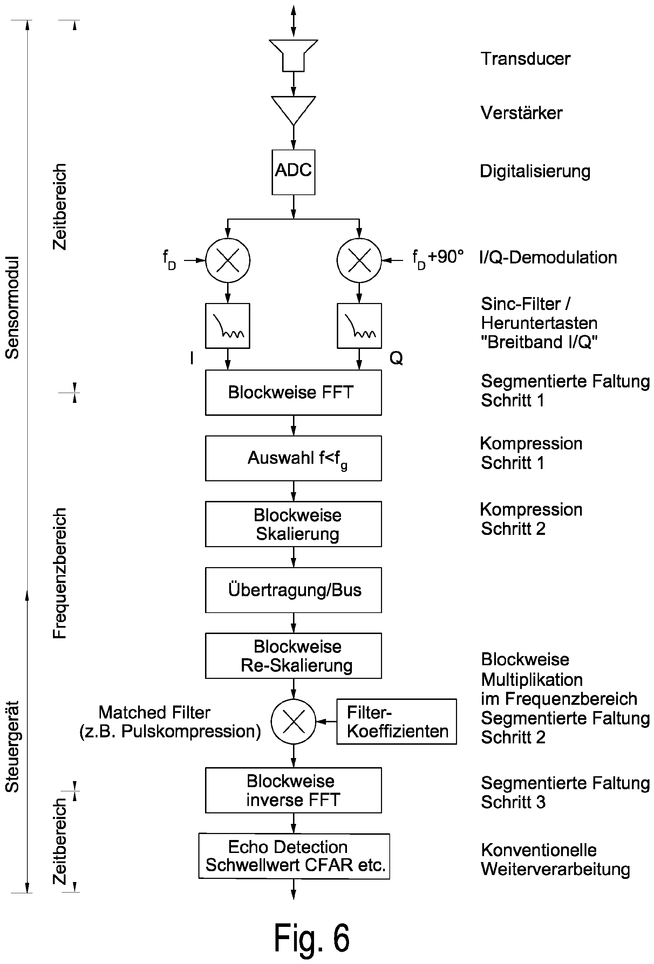

Der Ablauf der Datenkompression, die Übertragung der Daten sowie die Rücktransformation ist im Diagramm der Fig. 6 dargestellt.

Das Signal wird vom Transducer (Empfänger) aufgenommen und anschließend verstärkt und digitalisiert. Mit Hilfe eines Quadraturdemodulators wird es auf die Frequenz null verschoben und in die Inphasenanteile (I) und in die Quadraturanteile (Q) zerlegt. Das Sinc-Filter eliminiert die höheren Frequenzkomponenten, insbesondere werden die Anteile bei der Mischerfrequenz (hauptsächlich hervorgerufen durch den Offset von Verstärker und ADC) und bei dem doppelten der Mischerfrequenz exakt eliminiert. Anschließend wird die Abtastrate reduziert, z.B. auf einen Wert pro Signalperiode (entsprechend ~20 $\mu$s, s.o.). Das so entstandene Signal wird auch als analytisches Signal bezeichnet mit I als Real- und Q als Imaginärteil [4]. Dieses komplexwertige Signal wird nun blockweise mit Hilfe der schnellen Fouriertransformation (FFT) in den Frequenzbereich transformiert. Diejenigen Frequenzanteile, die höher als eine bestimmte Grenzfrequenz fg sind, werden verworfen. Die übrigen Werte werden nun so skaliert (z.B. durch eine Schiebeoperation, Multiplikation mit 2), dass sie mit einem deutlich kürzeren Datenwort dargestellt werden können (z.B. 8 statt 16 Bit). Danach erfolgt die Übertragung über den Datenbus.

In der Zentraleinheit werden die Daten als erstes auf ihren ursprünglichen Wertebereich re-skaliert. Anschließend erfolgt die Filterung im Frequenzbereich durch Multiplikation mit dem Frequenzgang des Filters. Der Vorteil ist, dass das Filter selbst nicht gerechnet werden muss: der Frequenzgang wird einfach nur im Speicher hinterlegt. Im letzten Schritt erfolgt die Rücktransformation in den Zeitbereich durch eine inverse Fouriertransformation (IFFT). Die weitere Verarbeitung der Echodaten, wie Bewertung mit statischen oder dynamischen Schwellwerten (CFAR) und vieles mehr (s.o.), erfolgt im Anschluss daran auf bekannte Art und Weise.

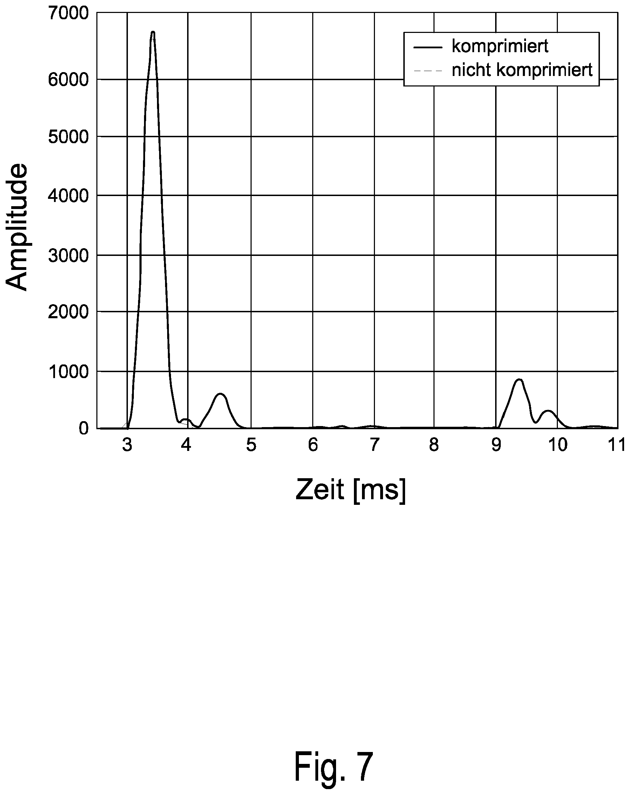

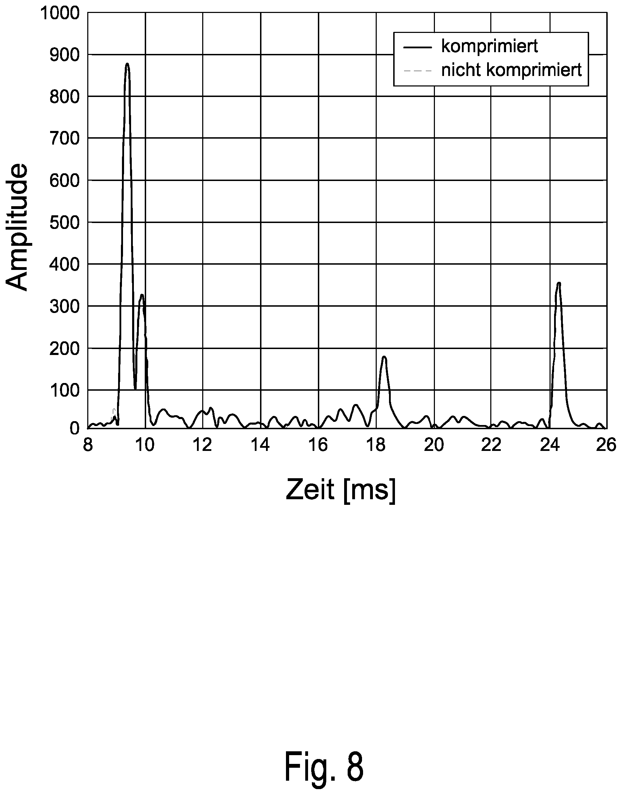

Die Kurven der Fign. 7 und 8 zeigen die Unterschiede zwischen einem datenreduzierten und einem nicht-datenreduzierten Signal.

- Sendefrequenz 50 kHz, Abtastzeit nach Demodulation 20 $\mu$s
- Ursprüngliche Datenrate: 500 Bytes/5 ms
- reduzierte Datenrate: 62 Bytes/5 ms
- Bandbreite (gemäß FFT Bins): +/- 2.4kHz
- FFT-Länge L = 64
- Länge der Impulsantwort des Matched-Filters Nh = 16
- Blockgröße: Ns = 49 Abtastwerte, entsprechend 0.98 ms
- Anzahl der berücksichtigten FFT-Bins (Frequenzwerte): 7
- Wortbreite der übertragenen Werte: 6 Bit

## LITERATUR

[1] Albrecht Ludloff, "Praxiswissen Radar und Radarsignalverarbeitung"
[2] https://de.wikipedia.org/wiki/Schnelle_Faltung
[3] US-A-5 502 747
[4] https://de.wikipedia.org/wiki/Analytisches_Signal

## Patentansprüche

**1.** Verfahren zur Übertragung von ein Ultraschallmesssignal einer Ultraschallmessvorrichtung insbesondere eines Fahrzeugs repräsentierenden Daten von einem Sender an einen Empfänger, wobei bei dem Verfahren

- im Sender

- ein digitalisiertes Analog-Ultraschallmesssignal als Reaktion auf ein zur Detektion von Hindernissen ausgesandtes Analog-Ultraschallsendesignal vorliegt,
- das Ultraschallmesssignal bei einem Mehrfachen seiner Frequenz abgetastet und in einzelne aufeinanderfolgende Blöcke von Abtastwerten unterteilt wird,
- die Abtastwerte des abgetasteten Ultraschallmesssignals blockweise in den Frequenzbereich transformiert werden, und zwar mittels segmentierter, schneller Faltung,
- diejenigen Frequenzanteile des Spektrums, deren Amplitude kleiner als ein vorgebbarer Schwellwert ist, oder die Frequenzanteile des Spektrums oberhalb eines oberen Frequenzgrenzwerts und/oder unterhalb eines unteren Frequenzgrenzwerts entfernt werden,
- der von dem verbleibenden Frequenzspektrum abgedeckte Amplitudenbereich zur weiteren Reduktion der Daten um einen Skalierungsfaktor skaliert wird, und

- von dem Sender die Daten jedes Blocks mit dem dem betreffenden Block jeweils zugeordneten Skalierungsfaktor an den Empfänger übertragen werden und
- im Empfänger

- die Skalierung des Amplitudenbereichs des Frequenzspektrums jedes Blocks mittels des jeweiligen Skalierungsfaktors wieder rückgängig gemacht wird,
- das so bearbeitete Frequenzspektrum durch Multiplikation mit den Filterkoeffizienten eines Optimalfilters zur Extraktion der Signalform des Analog-Ultraschallsendesignals aus dem im Sender vorliegenden Analog-Ultraschallmesssignal gefiltert wird und
- das derart gefilterte Frequenzspektrum blockweise in den Zeitbereich rücktransformiert wird, und zwar mittels inverser segmentierter, schneller Faltung.

2. Verfahren nach Anspruch 1, **dadurch gekennzeichnet, dass** die Skalierung erfolgt, indem in einem einen Amplitudenwert beschreibenden Amplituden-Bitwort mit L-Bits dasjenige höchstwertige Bit dieser L-Bits, das ungleich Null ist, identifiziert wird und dieses höchstwertige Bit sowie ausgehend von diesem die M-nächst niederwertigen Bits des Amplituden-Bitworts in ein Reduktions-Bitwort der Länge M + 1 mit M + 1 < L umgesetzt werden, wobei der Skalierungsfaktor die Anzahl derjenigen Bits des Amplituden-Bitworts repräsentiert, die höherwertig sind als das identifizierte höchstwertige Bit ungleich Null des Amplituden-Bitworts.

3. Verfahren nach Anspruch 2, **dadurch gekennzeichnet, dass** dann, wenn das identifizierte höchstwertige Bit ungleich Null des Amplituden-Bitworts niederwertiger als das (M + 1)-te Bit, vom niederwertigsten Bit des Amplituden-Bitworts an gerechnet, ist, diese (M + 1)-Bits des Amplituden-Bitworts die Bits des Reduktions-Bitworts sind, und dass der Skalierungsfaktor die Anzahl L - (M + 1) repräsentiert.

4. Verfahren nach einem der Ansprüche 1 bis 3, **dadurch gekennzeichnet, dass** das digitalisierte Analog-Ultraschallmesssignal einer I/Q-Demodulation unterzogen wird, wobei die Frequenz, mit der die I/Q-Demodulation durchgeführt wird, gleich der Frequenz des Ultraschallmesssignals ist.

## Claims

1. A method for transmitting data representing an ultrasonic measurement signal of an ultrasonic measuring device, in particular for a vehicle, from a transmitter to a receiver, wherein in the method:

- in the transmitter

- a digitized analog ultrasonic measurement signal is provided in reaction to an analog ultrasonic transmission signal emitted for detecting obstacles,
- the ultrasonic measurement signal is sampled at a multiple of its frequency and divided into individual successive blocks of sampling values,
- the sampling values of the sampled ultrasonic measurement signal are transformed in blocks into the frequency range using a segmented fast convolution,
- those frequency portions of the spectrum whose amplitude is smaller than a presettable threshold value, or the frequency portions of the spectrum above an upper frequency limit value and/or below a lower frequency limit value are removed,
- the amplitude range covered by the remaining frequency spectrum is scaled by a scaling factor for further reduction of the data, and

- from the transmitter the data of each block with the scaling factor assigned to the respective block are transmitted to the receiver, and
- in the receiver

- the scaling of the amplitude range of the frequency spectrum of each block is reversed using the respective scaling factor,
- the thus processed frequency spectrum is filtered out of the analog ultrasonic measurement signal provided in the transmitter by multiplication by filter coefficients of an optimum filter for extracting the signal shape of the analog ultrasonic transmission signal, and
- the thus filtered frequency spectrum is transformed in blocks back into the time range using an inverse segmented fast convolution.

2. The method according to claim 1, **characterized in that** the scaling is carried out by identifying, in an amplitude bit word having L bits and describing an amplitude value, that most significant bit of these L bits which is not equal to zero, and this most significant bit as well as, starting therefrom, the M next less significant bits of the amplitude bit word are converted to a reduction bit word of the length M + 1 with M + 1 < L, wherein the scaling factor represents the number of those bits of the amplitude bit word which are more significant than the identified most significant bit not equal to zero of the amplitude bit word.

3. The method according to claim 2, **characterized in that**, when the identified most significant bit not equal to zero of the amplitude bit word is less significant than the (M + 1)th bit, calculated as from the least significant bit of the amplitude bit word, these (M + 1) bits of the amplitude bit words are the bits of the reduction bit word and the scaling factor represents the number L - (M + 1).

4. The method according to any one of claims 1 to 3, **characterized in that** the digitized analog ultrasonic measurement signal is subjected to an I/Q demodulation, wherein the frequency at which the I/Q demodulation is carried out is equal to the frequency of the ultrasonic measurement signal.

**Revendications**

1. Procédé de transmission de données représentant un signal de mesure par ultrasons d'un dispositif de mesure par ultrasons en particulier d'un véhicule depuis un émetteur vers un récepteur, dans lequel, lors du procédé

   - dans l'émetteur

      - un signal de mesure par ultrasons analogique numérisé est présent en réaction à un signal d'émission ultrasonore analogique émis pour détecter des obstacles,
      - le signal de mesure par ultrasons est échantillonné à un multiple de sa fréquence et est divisé en blocs individuels consécutifs de valeurs échantillonnées,
      - les valeurs échantillonnées du signal de mesure par ultrasons échantillonné sont transformées par bloc en gamme de fréquences, à savoir au moyen d'une convolution segmentée rapide,
      - les composantes de fréquence du spectre dont l'amplitude est inférieure à une valeur seuil prédéfinissable, ou les composantes de fréquence du spectre au-dessus d'une limite de fréquence haute et/ou en-dessous d'une limite de fréquence basse sont enlevées,
      - la gamme d'amplitudes recouverte par le spectre de fréquences restant est redimensionnée selon un facteur d'échelle afin de réduire ultérieurement les données, et
      - les données de chaque bloc sont transmises avec le facteur d'échelle respectivement associé au bloc concerné depuis l'émetteur vers le récepteur et

   - dans le récepteur

      - le redimensionnement de la gamme d'amplitudes du spectre de fréquences de chaque bloc est inversé au moyen du facteur d'échelle respectif,
      - le spectre de fréquences ainsi traité est filtré par multiplication avec le coefficient de filtre d'un filtre accordé afin d'extraire la forme du signal du signal d'émission ultrasonore analogique à partir du signal de mesure par ultrasons analogique présent dans l'émetteur et
      - le spectre de fréquences ainsi filtré est ainsi transformé inversement en intervalle de temps, à savoir au moyen d'une convolution segmentée rapide inverse.

2. Procédé selon la revendication 1, **caractérisé en ce que** le redimensionnement s'effectue, le bit de poids fort parmi les L bits, lequel est non nul, étant identifié dans un mot binaire d'amplitude doté de L bits décrivant une valeur d'amplitude, et ce bit de poids fort ainsi que les M bits de poids inférieur suivants du mot binaire d'amplitude étant convertis en un mot binaire réduit de longueur M+1 où M+1<L, dans lequel le facteur d'échelle représente le nombre des bits du mot binaire d'amplitude qui sont de poids plus élevé que le bit de poids fort identifié et non nul du mot binaire d'amplitude.

3. Procédé selon la revendication 2, **caractérisé en ce qu'**ensuite, lorsque le bit de poids fort identifié et non nul du mot binaire d'amplitude est de poids plus bas que le (M+1)-ième bit, compté à partir du bit de poids faible du mot binaire d'amplitude, ces (M+1) bits du mot binaire d'amplitude sont les bits du mot binaire réduit, et **en ce que** le facteur d'échelle représente le nombre L-(M+1).

4. Procédé selon l'une des revendications 1 à 3, **caractérisé en ce que** le signal de mesure par ultrasons analogique numérisé est soumis à une démodulation I/Q, dans lequel la fréquence avec laquelle la démodulation I/Q est réalisée est égale à la fréquence du signal de mesure par ultrasons.

ADC

Vorverarbeitung

Datenreduktion

Übertragung/Bus

Daten-Rekonstruktion

Echo Detektion
Schwellwert CFAR etc.

Fig. 1

10

| L=Ms+Mh-1 |
|:---:|

| Ms | 0 |
|:---:|:---:|

| Mh | 0 |
|:---:|:---:|

# Fig. 2

Fig. 3

Fig. 4

EP 3 435 114 B1

| 1 | 1 | 0 | 0 | 0 | 1 | 1 | 0 | 0 | 1 | 1 | 0 | 1 | 0 | 0 | 0 | Bitwortlänge C=16

| 1 | 1 | 0 | 0 | 1 | 1 | 0 | 1 | Bitwortlänge (M+1)=8

Skalierungsfaktor 3

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0273820 A
- DE 102013015402 A
- EP 3171553 A
- US 5502747 A